(19) Europäisches Patentamt
European Patent Office
Office européen des brevets

(11) Veröffentlichungsnummer: **0 496 053 B1**

(12) **EUROPÄISCHE PATENTSCHRIFT**

(45) Veröffentlichungstag der Patentschrift: **26.07.95**

(51) Int. Cl.6: **C23C 14/06**, C23C 30/00, C23C 28/04, C23C 14/34, C23C 14/30

(21) Anmeldenummer: **91119840.6**

(22) Anmeldetag: **21.11.91**

(54) **Beschichtetes hochverschleissfestes Werkzeug und physikalisches Beschichtungsverfahren zur Beschichtung von hochverschleissfesten Werkzeugen.**

(30) Priorität: **21.01.91 CH 150/91**

(43) Veröffentlichungstag der Anmeldung:
**29.07.92 Patentblatt 92/31**

(45) Bekanntmachung des Hinweises auf die Patenterteilung:
**26.07.95 Patentblatt 95/30**

(84) Benannte Vertragsstaaten:
**BE CH DE ES FR GB IT LI NL SE**

(56) Entgegenhaltungen:
EP-A- 0 284 854      EP-A- 0 306 612
EP-A- 0 446 375      EP-A- 0 448 720
AU-B- 5 463 780      DD-A- 288 628

**PATENT ABSTRACTS OF JAPAN vol. 14, no. 377 (C-748)(4320) 15. August 1990**

**SURFACE AND COATINGS TECHNOLOGY Bd. 36, 11. April 1988, AMSTERDAM , NL Seiten265 - 273; O. KNOTEK ET AL.: 'ON REACTIVELY SPUTTERED TI-AL-V CARBONITRIDES'**

(73) Patentinhaber: **BALZERS AKTIENGESELLSCHAFT**

**FL-9496 Balzers (LI)**

(72) Erfinder: **Schulz, Hans, Dr.**
**Alte Churerstrasse 772**
**FL-9496 Balzers (LI)**
Erfinder: **Zehenter, Karl-Heinz**
**Hadeldorfstrasse 7**
**AT-6830 Rankweil (AT)**
Erfinder: **Bergmann, Erich, Dr.**
**Sarganserstrasse 58**
**CH-8887 Mels (CH)**

(74) Vertreter: **Keller, René, Dr. et al**
**Dr. R. Keller & Partner**
**Patentanwälte**
**Marktgasse 31**
**Postfach**
**CH-3000 Bern 7 (CH)**

PATENT ABSTRACTS OF JAPAN vol. 7, no.
273 (C-198)(1418) 6. Dezember 1983

**Beschreibung**

Die Erfindung betrifft ein beschichtetes hochverschleißfestes Werkzeug gemäß dem Oberbegriff des Patentanspruchs 1 sowie ein physikalisches Beschichtungsverfahren zur Beschichtung von hochverschleißfesten Werkzeugen gemaß dem Oberbegriff des Patentanspruchs 10.

Z. B. aus der DE PS 35 12 986 ist ein verschleißfest beschichtetes Werkzeug bekannt. Bei dem bekannten Werkzeug wurden mittels Kathodenzerstäubung oder einer anderen PVD(physical vapor deposition)-Methode auf einer metallischen Oberfläche mehrere Einzelschichten mit einer Schichtdicke zwischen 0,002 und 0,1 $\mu$m aufgebracht. Zum Aufbringen der Schichten wurden die Oberflächen der Werkzeuggrundkörper während des gesamten Beschichtungsvorganges relativ zu mindestens zwei Zerstäubungskathoden mit unterschiedlichem Hartstoffmaterial als Kathode bewegt. Als Zerstäubungskathoden wurden TiC und $TiB_2$, TiN und $TiB_2$, TiC und TiN und $TiB_2$, $TiB_2$ und WC, $TiB_2$ und Ti(C, N), $TiB_2$ und (Ti, V)C, $TiB_2$ und (Ti, W)C, (Ti, V)$B_2$ und (Ti, V)C, (Tl, Nb)$B_2$ und (Ti, Nb)C, $VB_2$ und TiN, $VB_2$ und WC, $HfB_2$ und TaC, $ZrB_2$ und TaC oder $ZrB_2$ und NbC verwendet. Es wurde hier auf die Ausbildung einer großen Anzahl von inneren Phasengrenzen in der Beschichtung Wert gelegt.

Die Standzeit obiger Werkzeuge läßt bei unterbrochenem Spanen mit hohen Geschwindigkeiten zu wünschen übrig.

Der Erfindung liegt die Aufgabe zugrunde ein hochverschleißfest beschichtetes Werkzeug zu schaffen, welches auch bei unterbrochenem Spanen mit hohen Geschwindigkeiten zufriedenstellende Ereignisse zeigt.

Die Lösung der Aufgabe ist hinsichtlich des Werkzeugs Gegenstand des Patentanspruchs 1 und hinsichtlich des Verfahrens zur Beschichtung des Werkzeugs Gegenstand des Patentanspruchs 10. Bevorzugte Ausführungsarten des Werkzeugs sind in den Patentansprüchen 2 bis 9 und des Verfahrens in den Patentansprüchen 11 bis 15 beschrieben.

Im folgenden wird ein Beispiel zur Herstellung eines erfindungsgemäßen Werkstücks anhand der Zeichnungen näher erläutert. Es zeigen:

Fig. 1  einen Schnitt durch eine schematisch dargestellte Aufdampfanlage,

Fig. 2  einen Schnitt durch die in Figur 1 dargestellte Aufdampfanlage entlang der Linie I - I, wobei aufgrund einer vorhandenen Rotationssymmetrie nur  eine Hälfte der Aufdampfanlage dargestellt ist, und

Fig. 3  den Verlauf der Titan- bzw. Aluminiumkonzentration in der mit der Aufdampfanlage auf einem Grundkörper aufgebrachten Schicht.

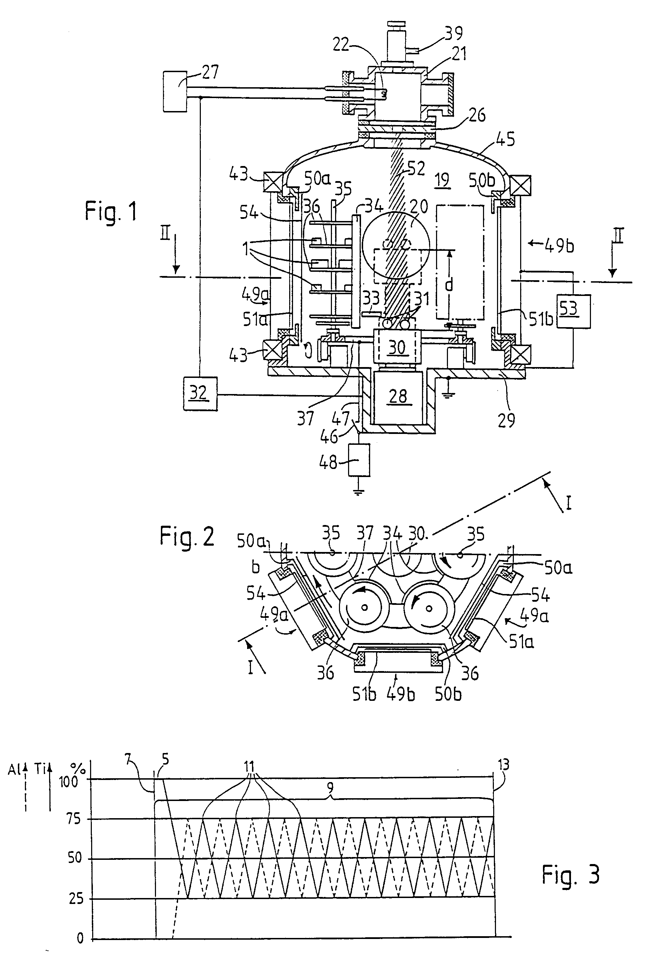

**Figur 1** zeigt eine schematische Darstellung einer beispielsweisen Aufdampfanlage zur Durchführung der erfindungsgemäßen hochverschleißfesten Beschichtung mit wechselnden Materialkonzentrationen. Die Aufdampfanlage hat eine Vakuumkammer **19** mit einem Evakuierungsanschluß **20** und eine von der Vakuumkammer **19** durch eine isoliert gehaltene Lochblende **26** elektrisch getrennte Glühkathodenkammer **21** mit einer Glühkathode **22**. Die Glühkathode **22** wird von einem Stromversorgungsgerät **27** gespeist. Unterhalb des Loches der Lochblende **26** befindet sich über dem Boden **29** der Vakuumkammer **19** ein kühlbarer in der Höhe verstellbarer Tiegel **30** mit Titan **31** als Aufdampfgut. Gestrichelt ist in **Figur 1** der Tiegel **30** um eine Distanz **d** von dessen unterster Position entfernt eingezeichnet. Die Höhenverstellung des Tiegels **30** erfolgt über eine in der Höhe verstellbare Bewegungseinrichtung **28**. Sie besteht aus drei mit einer Spindelführung ineinanderverschiebbaren Zylindern. Das im Tiegel **30** befindliche Titan **31** ist mit einer verschiebbaren Blende **33** abdeckbar. In der Vakuumkammer **19** sind sechs um die Längsachse drehbare, elektrisch leitende Träger **35**, von denen vier in **Figur 2** angedeutet sind, vorhanden, an denen zu beschichtende Grundkörper **1** der Werkzeuge aus Schnellstahl S 6-5-2 an je einer Halterung **36** gehalten werden. Die Träger **35** sind um ihre Achse drehbar auf einem Drehteller **37** angeordnet und durch diesen untereinander elektrisch verbunden. Der Drehteller **37** ist gegenüber dem Boden **29** und den Wänden der Vakuumkammer **19** elektrisch isoliert. Die Halterungen **36** sind mit den Trägern **35** elektrisch leitend verbunden. Die an den Halterungen **36** gehaltenen Grundkörper **1** sind mit einer in **Figur 1** und **2** schematisch dargestellten Blende **34** gegenüber dem im Tiegel **30** liegenden Titan **31** abdeckbar.

In die Glühkathodenkammer **21** mündet eine Gaszuleitung **39**, welche über das Loch der Lochblende **26** mit der Vakuumkammer **19** verbunden ist. Je eine schematisch dargestellte Magnetspule **43** befindet sich gerade oberhalb des Bodens **29** und am Anschluß eines Deckelteils **45** der Vakuumkammer **19** zur Erzeugung eines annähernd parallelen vertikalen Magnetfelds.

Der Drehteller **37** ist über eine elektrische Leitung **47** und einem schließbaren Schalter **46** mit einem einstellbaren Spannungsgenerator **48**, dessen anderer Pol geerdet ist, verbunden.

In den vertikalen Wänden der Vakuumkammer **19** sind alternierend drei Vorrichtungen **49a** und drei Vorrichtung **49b** zur Kathodenzerstäubung angeordnet, von denen drei in **Figur 2** dargestellt sind. Jede der

EP 0 496 053 B1

Vorrichtung **49a** und **49b** ist mit einem nicht dargestellten Wärmetauscher zur Kühlung versehen. Innerhalb eines Rings **50a** bzw. **50b** der Vorrichtung **49a** bzw. **49b** liegt ein von ihm isoliertes Target **51a** bzw. **51b** mit einer Titan-Aluminium-Legierung von fünfundzwanzig Atomprozent Titan, welches mit dem negativen Pol einer regelbaren Spannungsquelle **53** verbunden ist. Der positive Pol der Spannungsquelle **53** ist mit den Wänden der Vakuumkammer **19** und den Ringen **50a** und **50b** verbunden. Die Glühkathode **22** und der Tiegel **30** sind über elektrische Leitungen mit einem regelbaren Stromversorgungsgerät **32** verbunden. Die sechs Vorrichtungen **49a** und **49b** sind mit je einer in den **Figuren 1** und **2** schematisch dargestellten Blende **54** gegenüber den Grundkörpern **1** auf den Halterungen **36** abdeckbar.

Zur Beschichtung von Werkzeugen für spanende Bearbeitung z. B. von Bohrern oder Fräsern werden deren Grundkörper **1** an den Halterungen **36** der Träger **35** befestigt, Titan **31** in den Tiegel **30** gelegt sowie obige Targets **51a** und **51b** mit obiger Titan-Aluminium-Legierung von fünfundzwanzig Atomprozent Titan in die Vorrichtung **49a** bzw. **49b** eingesetzt. Anschließend wird die Vakuumkammer **19** geschlossen, evakuiert und die zu beschichtenden Oberflächen der Grundkörper **1** entsprechend einem in der DE-OS 34 06 953 bzw. der CH-PS 658 545 beschriebenen Verfahren mit einem von der Glühkathode **22** zum Tiegel **30** brennenden Niedervoltbogen **52** erhitzt und entsprechend einem in der CH-PS 631 743 beschrieben Verfahren gereinigt. Die Blende **33** bedeckt währenddessen das Titan **31** im Tiegel **30**.

Nach dem Erwärmen und Reinigen der zu beschichtenden Oberflächen der Grundkörper **1** wird mittels Ionenplattierung, wie z. B. in der DE-OS 28 23 876 beschrieben, eine Titanunterschicht auf den Grundkörper **1** aufgebracht. In die Vakuumkammer **19** wird über die Gaszuleitung **39** Argon eingelassen bis ein Partialdruck von 0,2 Pa erreicht ist. Die Grundkörper **1** sind elektrisch floatend. Die Drehteller **37** drehen sich mit den auf ihnen rotierenden Trägern **35** etwa mit sechs Umdrehungen pro Minute. Die zu beschichtenden Grundkörpern **1** rotieren an den Targets **51a** und **51b** vorbei. Die Blende **33** wird vom Titan **31**, die Blende **34** vor den Grundkörpern **1** weggeschoben und auf den Grundkörpern **1** eine hauchdünne Schicht **5** von einigen zehn Nanometer Titan aufgebracht.

Anschließend wird Stickstoff mit einhundertzwanzig Standardkubikzentimeter pro Minute durch die Gaszuleitung **39** in die Vakuumkammer **19** eingelassen und sobald der Stickstofffluß stabilisiert ist, wird Spannung an die Vorrichtungen **49a** und **49b** zur Kathodenzerstäubung und eine negative Spannung von etwa fünfzig Volt an den Drehteller **37** gelegt. Anschließend wird der Stickstofffluß auf zweihundertfünfzig Standardkubikzentimeter pro Minute erhöht, wodurch der Gesamtdruck in der Vakuumkammer **19** auf 0,3 Pa angehoben wird.

Die Strom des Niedervoltbogens **52** wird mit dem Stromversorgungsgerät **32** auf 200 A hochgeregelt und die Targetleistung mit der Spannungsquelle **53** auf 10 kW. Die Dampfflüsse des mit dem Niedervoltbogen aus dem Tiegel **30** verdampften und mittels Kathodenzerstäubung zerstäubten sowie teilweise ionisierten Titans und Aluminiums vereinigen sich mit dem Stickstoff in der Vakuumkammer **19** und schlagen sich auf den Grundkörpern **1** als Titan- und Aluminiumnitrid nieder. Während des ganzen Beschichtungsvorgangs wird der Bogenstrom zwischen 200 A und 160 A mit einer Rampe von etwa 20 A/min und die Leistung der Kathodenzerstäubung zwischen 10 kW und 15 kW mit einer Rampe von etwa 2,5 kW/min etwa dreieckförmig annähernd kontinuierlich gegenphasig zum Bogenstrom variiert. Nach vierzig Minuten ist dann auf der Oberfläche **7** des Grundkörpers **1** eine 4 μm dicke Schicht **9** mit zehn Titanverbindungskonzentrationsmaxima **11**, wie in **Figur 3** dargestellt, entstanden, wobei sich das Titan-Aluminium-Verhältnis in der niedergeschlagenen Beschichtung zwischen fünfundsiebzig zu fünfundzwanzig und fünfzig zu fünfzig Prozent kontinuierlich ändert, d. h. im Titanverbindungskonzentrationsmaximun **11** besteht die Beschichtung aus $Ti_{0.75}Al_{0.25}N$ und im Titanverbindungskonzentrationsminimum aus $Ti_{0.5}Al_{0.5}N$. In **Figur 3** ist der Verlauf der Titankonzentration als durchgezogene und der Verlauf der Aluminiumkonzentration als unterbrochene Kurve dargestellt. Die freie Oberfläche der Beschichtung **9** ist in **Figur 3** mit **13** bezeichnet.

Pendelt der Strom des Niedervoltbogens **52** um einen höheren Wert als oben angegeben, so läßt sich der Anteil des Titannitrids bis auf neunzig Prozent ($Ti_{0.9}Al_{0.1}N$) steigern. Analog läßt er sich durch einen niedrigeren mittleren Bogenstrom bis auf dreißig Prozent ($Ti_{0.3}Al_{0.7}N$) verringern.

Anstelle die Leistungen des Niedervoltbogens **52** und der Kathodenzerstäubungsvorrichtungen **49a** und **49b** zu verändern, kann auch der Tiegel **31** mit der Bewegungseinrichtung **28** einmal pro Minute bei einem konstanten Bogenstrom von 200 A auf- und abbewegt werden. Es kann auch während des Beschichtungsvorganges die Leistung des Niedervoltbogens **52**, die Leistung der Kathodenzerstäubungsvorrichtungen **49a** und **49b** verändert sowie der Tiegel **30** auf- und abbewegt werden.

Anstelle die Targets **49a** und **49b** mit einer Titan-Aluminium-Legierung zu verwenden, können auch die drei Targets **51a** aus Titan und die drei Targets **51b** aus Aluminium verwendet werden, wobei dann gegenüber den oben genannten Leistungen niedrigere Werte verwendet werden müssen.

Anstelle nur die reaktive Stickstoffatmosphäre zu verwenden, kann auch ein Stickstoff-Sauerstoff-Gemisch mit einem Kohlenstoff abgebenden Gas, wie z. B. Azethylen oder Äthan verwendet werden, wobei

4

der Sauerstoffgehalt unter dreißig Volumenprozent des Gemisches liegen sollte. Die Beschichtung besteht dann je nach eingestellter Leistung des Niedervoltbogens **52** und der Kathodenzerstäubungsvorrichtung **49a** und **49b** bei einer Titan-Aluminium-Legierung von obigen fünfundzwanzig zu fünfundsiebzig Atomprozent aus $Ti_{1-x}Al_xN_uC_vO_w$, wobei $u + v + w = 1$ und $w < 0,3$ ist.

Soll eine Karbonitridschicht mit $u = 0,7$, $v = 0,3$ und $w = 0$ erzeugt werden, so wird der Stickstofffluß auf 160 Standardkubikzentimeter reduziert und zusätzlich ein Azetylenfluß mit 100 Standardkubikzentimeter eingelassen. Die Prozeßparameter werden entsprechend angepaßt.

Die Anzahl der Titanverbindungskonzentrationsmaxima in der gesamten Beschichtung, die Schichtdicke sowie die Titanverbindungskonzentrationsmaxima pro Mikrometer Schichtdicke richten sich nach der Verwendung der beschichteten Werkzeuge, wobei bei Werkzeugen, welche für unterbrochenen Schnitt mit starker Schlagbeanspruchung verwendet werden, eine hohe Anzahl von Maxima gewählt wird und bei Werkzeugen für hauptsächlich kontinuierlichen Schnitt eine geringe Anzahl Maxima.

Wird der Abstand der Titanverbindungskonzentrationsmaxima zur freien Oberfläche der Beschichtung hin vergrößert, so erhöht sich der Widerstand gegen Abrasionsverschleiß, wobei sich bei Werkzeugverwendungen für einen hauptsächlich kontinuierlichen Schnitt bei stark abrasiven Werkstückstoffen ein Abstand des letzten Maximas von der freien Oberfläche von 0,5 $\mu$m bewährt hat.

Standzeituntersuchungen mit HSS-Spiralbohrern, welche nach obigem, eingangs beschriebenem, erfindungsgemäßem Verfahren beschichtet sind, sind in der untenstehenden Tabelle mit der Kennziffer **"4"** bezeichnet. Sie bestehen aus S 6-5-2 und haben einem Durchmesser von 6 mm. Ihr Grundkörper weist einen Schwefelgehalt von 0,029% auf und ist mit einer Festigkeit von 1050 N/mm² vergütet. Sie wurden zusammen mit nicht erfindungsgemäßen Bohrern Standzeituntersuchungen anhand einer Ermittlung einer charakteristischen Anzahl gebohrter Löcher unterzogen. Gebohrt wurde in Stahl 42CrMo4.

Mit der Kennziffer **"1"** sind Bohrer bezeichnet, welche eine nicht erfindungsgemäße Titannitridbeschichtung tragen, welche nur mit dem Niedervoltbogen aufgebracht wurde. In den ersten drei Minuten wurde bei einem Strom von 80 A Titan verdampft, ohne daß Stickstoff in die Vakuumkammer **19** eingelassen wurde. Nachdem sich eine wenige Nanometer dicke Titanhaftschicht auf dem Grundkörper **1** ausgebildet hatte, wurde der Strom des Niedervoltbogens auf 200 A erhöht und mit einer Rampenfunktion Stickstoff bis zu einem Partialdruck vom $4 \cdot 10^{-4}$ mbar in die Vakuumkammer eingelassen. Nach einer Beschichtungszeit von sechzig Minuten war auf den Grundkörpern eine 4 $\mu$m Titannitridschicht aufgebracht.

Mit der Kennziffer **"2"** sind Bohrer bezeichnet, welche eine nicht erfindungsgemäße Titanaluminiumnitridbeschichtung tragen, welche derart hergestellt wurden, daß zusätzlich zu dem unter **"1"** beschriebenen Beschichtungsverfahren Titan und Aluminium zerstäubt wurden. Als Targetzusammensetzung wurden 25 % Titan und 75 % Aluminium gewählt. Es wurde ebenfalls eine Titanhaftschicht aufgebracht. Auf diese Titanhaftschicht wurde innerhalb von fünf Minuten eine 0,3 $\mu$m dicke Titannitridzwischenschicht aufgebracht. Danach wurde die Leistung der Kathodenzerstäubungsvorrichtung auf 10 kW und der Bogenstrom des Niedervoltbogens auf 200 A hochgefahren. Diese Betriebsdaten wurden fünfunddreißig Minuten beibehalten, bis eine 4 $\mu$m dicke Beschichtung einer Titanaluminiumnitridschicht mit einem Titan- zu Aluminiumatomprozentverhältnis von fünfundsiebzig zu fünfundzwanzig erhalten wurde.

Mit der Kennziffer **"3"** sind Bohrer bezeichnet, welche eine nicht erfindungsgemäße Titanaluminiumnitridbeschichtung tragen, welche analog zu den Bohrern mit der Kennziffer **"2"** beschichtet wurden. Es wurde lediglich ein Bogenstrom des Niedervoltbogens von 160 A und eine Leistung der Kathodenzerstäubungsvorrichtung von 15 kW verwendet, worauf bei einer Beschichtungszeit von fünfundvierzig Minuten eine 4 $\mu$m dicke Beschichtung mit einem Titan- zu Aluminiumatomprozentverhältnis von fünfzig zu fünfzig erhalten wurde.

Als Schnittbedingungen für die Standzeituntersuchung wurde gewählt:
- Schnittgeschwindigkeit 47 m/min,
- Vorschub 0,125 mm/U,
- Kühlung mit 3 % Emulsion,
- Tiefe einer Durchgangsbohrung 15 mm,
- Anzahl der Testbohrer 10,
- Ende der Standzeit: Blankbremsung,
- bei der charakteristischen Lochzahl tritt eine 65 %-ige Ausfallwahrscheinlichkeit auf.

| Kennziffer | charakteristische Lochzahl |
|---|---|
| "1" | 550 |
| "2" | 670 |
| "3" | 630 |
| "4" | 1010 |

Analog zu obigen Bohrern wurden auch Standzeituntersuchungen an Wendeschneidplatten aus HSS durchgeführt. Verfahrensbedingt betrug die Beschichtungsdicke auf der Spanfläche 5 $\mu$m und auf der Freifläche 4 $\mu$m. Die Plattengeometrie war SCFT 120508 FN. Mit den Wendeplatten wurden Wellen aus unlegiertem Stahl CK60 zerspant.

Als Längsdrehbedingungen für die Standzeituntersuchung wurde gewählt:

- Schnittgeschwindigkeit 55 m/min,
- Vorschub 0,2 mm/Umdrehung,
- Schnitttiefe 2 mm,
- Kühlung mit 3 % Emulsion,
- als charakteristischen Standzeit in Minuten dient das Erreichen einer Kolktiefe von 100 $\mu$m.

| Kennziffer | charakteristische Standzeit |
|---|---|
| "1" | 8 Minuten |
| "2" | 11 Minuten |
| "3" | 13,5 Minuten |
| "4" | 17 Minuten |

Bei weiteren Untersuchungen anhand eines charakteristischen Standwegs an vierschneidigen Schaftfräsern aus S 6-5-2-10 mit einem Durchmesser von 10 mm wurde der Einfluß einer unterschiedlichen Anzahl von Titanverbindungskonzentrationsmaxima anhand einer oben erwähnten Karbonitridbeschichtung $Ti_{1-x}Al_xN_uC_v$ mit u = 0,7 und v = 0,3 (w = 0) pro Mikrometer Schichtdicke untersucht.

In der untenstehenden Tabelle sind unter der Kennziffer **"5"** Schaftfräser mit einer nicht erfindungsgemäßen Beschichtung mit einem konstanten Titan- zu Aluminium-Atomverhältnis aufgeführt, wobei ein Titan- zu Aluminium-Atomverhältnis zwischen fünfundsiebzig zu fünfundzwanzig und fünfzig zu fünfzig gewählt wurde. Es hat sich bei der Durchführung der Untersuchungen gezeigt, daß ein unterschiedliches Titan- zu Aluminium-Atomverhältnis in obigem Rahmen nicht in den charakteristischen Standweg eingeht.

Mit der Kennziffer **"6"** sind erfindungsgemäß beschichtete Schaftfräser mit 10 Titanverbindungskonzentrationsmaxima und mit Kennziffer **"7"** deren mit 100 Titanverbindungskonzentrationsmaxima pro 4 um aufgeführt, wobei das Titan- zu Aluminiumatomprozentverhältnis in der Beschichtung sich zwischen fünfundsiebzig zu fünfundzwanzig und fünfzig zu fünfzig ändert.

Zur Bestimmung des charakteristischen Standweges für obige Schaftfräser wurden folgende Bedingungen gewählt:

- zerspanter Werkstoff GG 25,
- Schnittgeschwindigkeit 60 m/min,
- Vorschub 0,125 mm/Umdrehung,
- Schnitttiefe 3 mm,
- keine Kühlung,
- als charakteristischer Standweg dient das Erreichen einer Verschleißmarkenbreite von 200 $\mu$m.

| Kennziffer | charakteristischer Standweg |
|---|---|
| "5" | 7,5 m |
| "6" | 11 m |
| "7" | 13 m |

In einer weiteren untenstehenden Tabelle sind weitere Untersuchungen an Einstechwerkzeugen dargelegt. Einstechwerkzeuge mit der Kennziffer **"8"** bestehen aus einem Hartmetall der Sorte M15 ohne Beschichtung. Diejenigen mit der Kennziffer **"9"** sind mit einer nicht erfindungsgemäßen Beschichtung mit einem konstanten Titan- zu Aluminium-Atomverhältnis versehen, wobei auch hier der Wert des Titan- zu Aluminium-Atomverhältnisses nicht eingeht.

Unter den Kennziffern **"10"** und **"11"** sind analog zu den obigen Schaftfräsern mit den Kennziffern **"6"** und **"7"** erfindungsgemäß beschichtete Einstechwerkzeuge aufgeführt.

Zur Bestimmung einer charakteristischen Standmenge der Einstechwerkzeuge wurden Wellen aus X2NiCrMo 18 10 mit 2,5 mm tiefen Nuten unter folgenden Bedingungen versehen, wobei unter der Standmenge die Anzahl gefräster Nuten unter den nachfolgenden Bedingungen verstanden wird:

- Schnittgeschwindigkeit am Außendurchmesser der Welle 160 m/min,
- Vorschub 0,05 mm/Umdrehung,
- Schnitttiefe 3 mm,
- Kühlung,
- als charakteristisches Standkriterium dient das Erreichen einer Rauhigkeit auf der Oberfläche der Nut von $R_2 > 1,5\ \mu$m.

| Kennziffer | Anzahl gefräster Nuten |
|------------|------------------------|
| "8" | 50 |
| "9" | 80 |
| "10" | 90 |
| "11" | 130 |

Auch die Verwendung der oben erwähnten erfindungsgemäßen Oxykarbonitridbeschichtung mit kontinuierlich wechselnden Metallverbindungskonzentrationen ergibt eine erhöhte Standzeit derartig beschichteter Werkzeuge.

Die erhöhte Lochzahl, die erhöhte Standzeit, der erhöhte Standweg und die erhöhte Standmenge, welche mit den erfindungsgemäß beschichteten Werkzeugen erreichbar sind, lassen sich eindeutig aus den oben ausgeführten Beispielen ersehen.

## Patentansprüche

1. Beschichtetes hochverschleißfestes Werkzeug, **gekennzeichnet durch**
   eine $Me^1_{1-x} \bullet (\alpha_2 Me^2 \bullet \alpha_3 Me^3 \bullet \ ... \ \alpha_n Me^n)_x N_u C_v O_w$-Beschichtung, in der die $Me^1$-Konzentration im Verhältnis zur $(\alpha_2 Me^2 \bullet \alpha_3 Me^3 \bullet \ ... \ \alpha_n Me^n)$-Konzentration über der Schichtdicke zwei bis fünfzig Mal pro Mikrometer Schichtdicke zwischen relativen Maxima und Minima von $Me^1$ kontinuierlich wechselt, wobei $Me^1$ ein Metall der chemischen Gruppe IVb des Periodensystems ist,
   $Me^2$, $Me^3$, ..., $Me^n$ andere Metalle aus derselben oder einer anderen chemischen Gruppe sind,
   $\alpha_2$, $\alpha_3$, ... $\alpha_n$ die Mischanteile der anderen Metalle untereinander bezeichnen, u, v, w und x zwischen 1 und Null liegen und $u + v + w = 1$ ist sowie
   x zwischen 0,1 und 0,7 liegt.

2. Werkzeug nach Anspruch 1, **dadurch gekennzeichnet,** daß
   v und/oder w annähernd Null ist bzw. sind.

3. Werkzeug nach Anspruch 1 oder 2, **dadurch gekennzeichnet,** daß
   w < 0,3 ist.

4. Werkzeug nach einem der Ansprüche 1 bis 3**, dadurch gekennzeichnet,** daß
   das oder die anderen Metalle $Me_2$, $Me_3$, ..., $Me^n$ andere Metalle der chemischen Gruppe IVb des Periodensystems und/oder Vanadium und/oder bevorzugt Aluminium sind.

5. Werkzeug nach einem der Ansprüche 1 bis 4, **dadurch gekennzeichnet,** daß
   in der Beschichtung pro Mikrometer Schichtdicke acht bis fünfzehn relative Titanverbindungskonzentrationsmaxima vorhanden sind.

6. Werkzeug nach Anspruch 5, **dadurch gekennzeichnet,** daß
   der Abstand der relativen $Me^1$-Konzentrationsmaxima zur freien Oberfläche der Beschichtung hin zunimmt.

**7.** Werkzeug nach einem der Ansprüche 1 bis 6, **dadurch gekennzeichnet,** daß
die Schichtdicke der Beschichtung ein bis sieben, bevorzugt zwei bis vier Mikrometer beträgt.

**8.** Werkzeug nach einem der Ansprüche 1 bis 7, **dadurch gekennzeichnet,** daß
die Beschichtung aus einphasigem, bevorzugt kubisch flächenzentriertem Material besteht.

**9.** Werkzeug nach einem der Ansprüche 1 bis 8, **dadurch gekennzeichnet,** daß
der $Me^{1-}$ Konzentrationsverlauf über der Schichtdicke eine wenigstens annähernd stetige Funktion ist.

**10.** Physikalisches Beschichtungsverfahren zur Beschichtung von hochverschleißfesten Werkzeugen gemäß
einem der Ansprüche 1 bis 9, **dadurch gekennzeichnet,** daß
das Verhältnis mindestens zweier Dampfflüsse unterschiedlichen Metalls auf die Grundkörper **(1)** der
Werkzeuge derart alternierend variiert wird, daß
auf den Grundkörpern **(1)** eine Beschichtung mit einem kontinuierlichen Konzentrationsverlauf zwischen
zwei bis fünfzig relativen Konzentrationsmaxima und -minima pro Mikrometer Schichtdicke erhalten
wird.

**11.** Beschichtungsverfahren nach Anspruch 10, **dadurch gekennzeichnet,** daß
zur Änderung der Dampfflüsse der relative Abstand der Grundkörper **(1)** zu mindestens einer
Dampfquelle verändert wird.

**12.** Beschichtungsverfahren nach Anspruch 10 oder 11, **dadurch gekennzeichnet,** daß
wenigstens einer der Dampfflüsse mit einer Bogenentladung erzeugt wird.

**13.** Beschichtungsverfahren nach Anspruch 12, **dadurch gekennzeichnet,** daß
die Bogenentladungsleistung während des Beschichtungsvorganges entsprechend eines vorgegebenen
abzuscheidenden Materialkonzentrationsverlaufes auf dem Grundkörper **(1)**, vorzugsweise um etwa
20%, annähernd kontinuierlich verändert wird.

**14.** Beschichtungsverfahren nach einem der Ansprüche 10 bis 13, **dadurch gekennzeichnet,** daß
wenigstens einer der Dampfflüsse mittels Zerstäubung erzeugt und die Zerstäubungsleistung während
des Beschichtungsvorganges entsprechend eines vorgegebenen abzuscheidenden Materialkonzentrationsverlaufs auf dem Grundkörper **(1)**, vorzugsweise um etwa 30%, annähernd kontinuierlich verändert
wird.

**15.** Beschichtungsverfahren nach einem der Ansprüche 10 bis 14, **dadurch gekennzeichnet,** daß
wenigstens einer der Dampfflüsse durch Verdampfen einer Legierung erzeugt wird.

**Claims**

**1.** Coated highly abrasion-resistant tool, characterised in that
a $Me^1_{1-x}$ $(\alpha_2 Me^2 . \alpha_s ME^3 ... \alpha_n Me^n)_x N_u C_v O_w$-layer, in which the ratio of the $Me^1$-concentration to the
$(\alpha_2 Me^2 . \alpha_3 Me^3 ... \alpha_n Me^n)$-concentration throughout the thickness of the layer changes continuously two
to fifty times per micrometre of layer thickness between relative maxima and minima of $Me^1$, in which
$Me^1$ is a metal from the chemical group IVb of the periodic table,
$Me^2$, $Me^2$, ..., $Me^n$ are other metals from the same or a different chemical group,
$\alpha_2$, $\alpha_3$ ..., $\alpha_n$ are the proportions in which the other metals are mixed with each other, u, v, w, and x lie
between 1 and zero and $u + v + W = 1$ and
x lies between 0.1 and 0.7.

**2.** A tool as claimed in claim 1, characterised in that
v and/or w is or are close to zero.

**3.** A tool as claimed in claim 1 or 2, characterised in that
W <0.3.

**4.** A tool as claimed in one of claims 1 to 3, characterised in that
the other metal or metals $Me_2$, $Me_3$, ..., $Me^n$ are other metals from the chemical group IVb of the

EP 0 496 053 B1

periodic table and/or vanadium and/or preferably aluminium.

5. A tool as claimed in one of claims 1 to 4, characterised in that
eight to fifteen relative titanium bonding concentration maxima are present in each micrometre of layer thickness.

6. A tool as claimed in claim 5, characterised in that
the distance of the relative $Me^1$-concentration maxima increases towards the free surface of the coating.

7. A tool as claimed in one of claims 1 to 6, characterised in that
the thickness of the layer of the coating is one to seven, and preferably two to four, micrometres.

8. A tool as claimed in one of claims 1 to 7, characterised in that
the coating is made from a single-phase, and preferably a cubic close packed, material.

9. A tool as claimed in one of claims 1 to 8, characterised in that
the dispersion of the $Me^1$-concentration over the thickness of the layer is a function that is at least almost constant.

10. A physical coating method for coating highly abrasion-resistant tools as claimed in one of claims 1 to 9, characterised in that
the ratio of at least two vapour flows of different metals are varied alternately on the body (1) so that a layer is obtained on the body (1) with a continuous dispersion of concentration between two and fifty relative concentration maxima and minima per micrometre of layer thickness.

11. A coating method as claimed in claim 10, characterised in that
to change the vapour flows, the relative distance between the body (1) and at least one vapour source is modified.

12. A coating method as claimed in claim 10 or 11, characterised in that
at least one of the vapour flows is produced by arc discharge.

13. A coating method as claimed in claim 12, characterised in that
during the coating process in which a given separate deposition of material concentration is applied to the body (1), the arc discharge is continuously modified, preferably by about 20%.

14. A coating method as claimed in one of claims 10 to 13, characterised in that
at least one of the vapour flows is produced by means of spraying and the spray itself is continuously modified, preferably by about 30%, during the coating process in which a given separate deposition of material concentration is applied to the body (1).

15. A coating method as claimed in one of claims 10 to 14, characterised in that
at least one of the vapour flows is produced by evaporation of an alloy.

**Revendications**

1. Outil revêtu à haute résistance à l'usure, caractérisé par
un revêtement $Me^1_{1-x} \cdot (\alpha_2 Me^2 \cdot \alpha_3 Me^3 \dots \alpha_n Me^n)_x N_u C_v O_w$- dans lequel la concentration en $Me^1$ - par rapport à la concentration en $(\alpha_2 Me^2 \cdot \alpha_3 Me^3 \dots \alpha_n Me^n)$ - sur l'épaisseur de couche varie en continu entre deux à cinquante fois par micron d'épaisseur de couche entre des maxima et des minima relatifs de $Me^1$,
$Me^1$ étant un métal du groupe chimique IVb de la classification périodique des éléments,
$Me^2$, $Me^3$, ..., $Me^n$ sont d'autres métaux à partir du même groupe chimique ou d'un autre groupe chimique,
$\alpha_2$, $\alpha_3$, ..., $\alpha_n$ désignant des quantités de mélange des autres métaux entre eux, u, v, w et x se situant entre 1 et 0 et $u + v + w = 1$ ainsi qu'
x entre 0,1 et 0,7.

9

**2.** Outil selon la revendication 1, caractérisé en ce que
v et/ou w est ou sont proches de 0.

**3.** Outil selon la revendication 1 ou 2, caractérisé en ce que
w < 0,3.

**4.** Outil selon l'une des revendication 1 à 3, caractérisé en ce que
le ou les autres métaux $Me_2$, $Me_3$, ..., $Me^n$ sont d'autres métaux du groupe chimique IVb de la classification périodique des éléments et/ou le vanadium et/ou de préférence l'aluminium.

**5.** Outil selon l'une des revendications 1 à 4, caractérisé en ce que,
dans le revêtement par micron d'épaisseur de couche sont présents huit jusqu'à quinze maxima relatifs de concentration de composé titane.

**6.** Outil selon la revendication 5, caractérisé en ce que
l'écart des maxima relatifs de concentration $Me^1$ augmente en direction de la superficie libre du revêtement.

**7.** Outil selon l'une des revendications 1 à 6 caractérisé en ce que
l'épaisseur de couche du revêtement est de un jusqu'à sept, de préférence de deux jusqu'à quatre microns.

**8.** Outil selon l'une des revendications 1 à 7, caractérisé en ce que
le revêtement est constitué par un matériau monophase, de préférence à faces centrées cubiquement.

**9.** Outil selon l'une des revendications 1 à 8, caractérisé en ce que
l'allure de concentration $Me^1$ sur l'épaisseur de couche est une fonction au moins pratiquement constante.

**10.** Procédé de revêtement physique pour le revêtement d'outil à forte résistance à l'usure selon l'une des revendication 1 à 9, caractérisé en ce que
le rapport d'au moins deux flux de vapeur de différents métaux sur les corps de base (1) des outils varient de façon alternée de telle manière que sur les corps de base 1 on obtient un revêtement ayant une allure de concentration continue entre deux jusqu'à cinquante maxima et minima de concentration relative par micron d'épaisseur de couche.

**11.** Procédé de revêtement selon la revendication 10, caractérisé en ce que
pour la modification des flux de vapeur, la distance relative des corps de base (1) varie par rapport à au moins une source de vapeur.

**12.** Procédé de revêtement selon la revendication 10 ou 11, caractérisé en ce qu'
au moins l'un des flux de vapeur est produit par décharge d'arc électrique.

**13.** Procédé selon la revendication 12, caractérisé en ce que
la performance de décharge d'arc électrique pendant l'opération de revêtement est modifiée pratiquement de façon continue selon l'allure de concentration de matériaux prédéterminés à séparer sur le corps de base (1), de préférence d'environ 20%.

**14.** Procédé de revêtement selon l'une des revendications 10 à 13, caractérisé en ce qu'
au moins l'un des flux de vapeur est produit par atomisation et la capacité d'atomisation pendant l'opération de revêtement est modifiée approximativement de façon continue selon une allure de concentration de matériaux à séparer, prédéterminés sur le corps de base (1), de préférence d'environ 30%.

**15.** Procédé de revêtement selon l'une des revendications 10 à 14, caractérisé en ce qu'
au moins l'un des flux de vapeur est produit par vaporisation d'un alliage.

EP 0 496 053 B1

Fig. 1

Fig. 2

Fig. 3

11